# EUROPEAN PATENT APPLICATION

(11) **EP 4 742 866 A1**
(43) Date of publication of application: **13.05.2026**
(21) Application number: 24838419.0
(22) Date of filing: 11.05.2024
(51) Int. Cl.: H10K 30/85, H10F 71/00

(54) **PEROVSKITE SOLAR CELL AND PREPARATION METHOD THEREFOR, PHOTOVOLTAIC MODULE, SYSTEM, AND ELECTRIC DEVICE**

(30) Priority: 12.07.2023 CN 202310855619
(71) Applicant: Contemporary Amperex Future Energy Research Institute (Shanghai) Limited, Shanghai 200241 (CN); Contemporary Amperex Technology Co., Limited, Ningde, Fujian 352100 (CN)
(72) Inventor: GU, Shuai, Shanghai 200241 (CN); JIA, Boyu, Shanghai 200241 (CN); LIU, Tianyu, Shanghai 200241 (CN); CHEN, Chen, Shanghai 200241 (CN); CHEN, Guodong, Shanghai 200241 (CN); GUO, Yongsheng, Shanghai 200241 (CN); CHEN, Junchao, Shanghai 200241 (CN)
(74) Representative: Gong, Jinping
(86) International application number: PCT/CN2024/092664
(87) International publication number: WO 2025/011160

(57) **Abstract**

A perovskite solar cell and a preparation method thereof, a photovoltaic module, a system, and an electric device are provided. The perovskite solar cell includes a transparent electrode layer and, a perovskite layer, an electron transport layer, and a metal electrode sequentially disposed on the transparent electrode layer; where the electron transport layer includes an organic electron transport material, a first additive, and a second additive; the first additive includes one or more of polymethyl methacrylate, methacrylic acid-methyl methacrylate copolymer, 4-vinylpyridine-styrene copolymer, polyacrylonitrile, and poly(4-vinylpyridine); and the second additive includes one or more of a compound of formula I and a compound of formula II. The perovskite solar cell of this application has high photoelectric conversion efficiency and good stability.

## Description

### CROSS-REFERENCE

This application claims priority to Chinese Patent Application No. 202310855619.X, filed on July 12, 2023 and entitled "PEROVSKITE SOLAR CELL AND PREPARATION METHOD THEREOF, PHOTOVOLTAIC MODULE, SYSTEM, AND ELECTRIC DEVICE", which is incorporated herein by reference in its entirety.

### TECHNICAL FIELD

This application relates to the technical field of solar cells, and in particular to a perovskite solar cell, a photovoltaic module, a system, and an electric device.

### BACKGROUND ART

With the rapid development in the field of new energy, solar cells have been widely used in the fields such as industry, commerce, agriculture, and communications. Perovskite solar cells (perovskite solar cells, PSCs) are devices that utilize the photoelectric conversion mechanism of perovskite-type crystal materials to convert solar energy into electrical energy, representing the current third-generation solar cells. They offer multiple advantages including high photoelectric conversion efficiency, simple fabrication processes, and low production costs, and have been extensively researched in recent years.

With the maturation of processes for organic electron transport layer materials such as fullerene derivatives, naphthalene diimide, and perylene diimide, along with continuous price reductions, organic electron transport layer materials are gradually becoming suitable for industrialized large-scale production. Organic electron transport layer materials can improve the hysteresis of devices and enhance photoelectric conversion efficiency to a certain extent. However, the photoelectric conversion efficiency of current perovskite solar cells using organic electron transport layer materials still needs further improvement, and the stability of such cells is relatively poor.

Therefore, improving the photoelectric conversion efficiency and stability of perovskite solar cells using organic materials as electron transport layers is one of the key issues that urgently need to be resolved in this field.

### SUMMARY OF THE INVENTION

This application is made in view of the above-mentioned issues, and one of its objectives is to provide a perovskite solar cell having high photoelectric conversion efficiency and good stability.

To achieve the above objective, a first aspect of this application provides a perovskite solar cell, including a transparent electrode layer and, a perovskite layer, an electron transport layer, and a metal electrode sequentially disposed on the transparent electrode layer; where
the electron transport layer includes an organic electron transport material, a first additive, and a second additive;
the first additive includes one or more of polymethyl methacrylate, methacrylic acid-methyl methacrylate copolymer, 4-vinylpyridine-styrene copolymer, polyacrylonitrile, and poly(4-vinylpyridine); and
the second additive includes one or more of the following compound of formula I and compound of formula II: 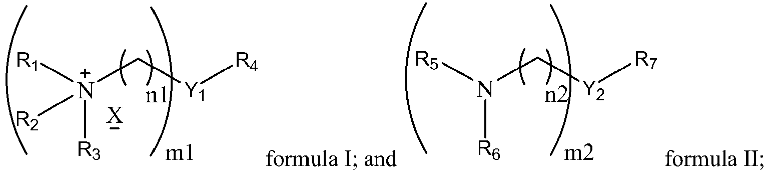
where R₁, R₂, R₃, R₅, and R₆ are each independently selected from C₁-C₄ alkyl; n1 and n2 are each independently an integer from 1 to 6; m1 and m2 are each independently an integer from 1 to 4; R₄ and R₇ are each independently selected from C₁-C₅ alkyl, C₁₋C₅ alkoxy, C₁-C₅ alkylthio, aryl, halogen, carboxyl, cyano, or absent; X is one or more of Cl, Br, I, BF₄, PF₆, and TFSI (bis(trifluoromethanesulfonyl)imide); and Y₁ and Y₂ are each independently selected from any one of CH₂, NH, O, and S, or absent.

In the perovskite solar cell of this application, a specific organic polymer as the first additive is added to the electron transport layer containing the organic electron transport material, and specific quaternary ammonium salts and/or tertiary amine molecules as the second additive are added. The introduction of the first additive organic polymer can improve the dispersibility of the organic electron transport material in the solution for forming the electron transport layer, enhance the film uniformity of the electron transport layer, and reduce channels for water molecules to penetrate into the electron transport layer. The second additive quaternary ammonium salts can significantly improve the film conductivity of the electron transport layer; the second additive tertiary amine molecules can enhance the binding force between organic electron transport material molecules; the above quaternary ammonium salts and tertiary amine molecules can form a passivation layer at the perovskite interface during the molecular crystallization of the electron transport layer, thereby reducing the diffusion of perovskite ions. Through the synergistic effect of the above specific first additive and second additive, the photoelectric conversion efficiency and stability of the perovskite solar cell can be improved.

In any embodiment, based on a total mass of the electron transport layer, a mass fraction of the first additive is 1% to 5%, a mass fraction of the second additive is 0.5% to 2%, and a mass fraction of the organic electron transport material is 93% to 98.5%. In this way, the photoelectric conversion efficiency and stability of the perovskite solar cell can be further improved.

In any embodiment, the second additive includes the compound of formula I and the compound of formula II, and a mass ratio of the compound of formula I to the compound of formula II is (0.5 to 2):1. In this way, the photoelectric conversion efficiency and stability of the perovskite solar cell can be further improved.

In any embodiment, the compound of formula I includes one or more of tetrabutylammonium tetrafluoroborate, hexamethylenediammonium iodide, and dodecyltrimethylammonium bromide.

In any embodiment, the compound of formula II includes one or more of 1,7-bis(dimethylamino)heptane, tris(dimethylaminopropyl)amine, and 9,9-bis[3-(dimethylamino)propyl]fluorene.

In any embodiment, a thickness of the electron transport layer is 25 nm to 45 nm.

In any embodiment, the organic electron transport material includes one or more of fullerene derivatives, naphthalene diimide and derivatives thereof, and perylene diimide and derivatives thereof.

A second aspect of this application provides a method for preparing a perovskite solar cell, including the following steps:
providing a transparent electrode layer; and
sequentially forming a perovskite layer, an electron transport layer, and a metal electrode on the transparent electrode layer;
where a solution for forming the electron transport layer includes a solvent and a solute dispersed in the solvent, and the solute includes an organic electron transport material, a first additive, and a second additive.

By adding the specific first additive and second additive to the solution for preparing the electron transport layer, the photoelectric conversion efficiency and stability of the perovskite solar cell can be improved.

In any embodiment, the solvent includes a first organic solvent and a second organic solvent, a boiling point of the first organic solvent is 38°C to 90°C, and a boiling point of the second organic solvent is 110°C to 210°C. In this way, the first organic solvent is a low-boiling-point solvent, and the second organic solvent is a high-boiling-point solvent. By using a mixed solvent of the above first organic solvent and second organic solvent, and dispersing the organic electron transport material, the first additive, and the second additive in this mixed solvent system, the crystallization sequence and uniformity of the organic electron transport material molecules as well as the first additive and second additive can be optimized, molecular orientation can be guided, the film quality and conductivity of the electron transport layer can be enhanced, and the photoelectric conversion efficiency and stability of the perovskite solar cell can be improved.

In any embodiment, the first organic solvent includes one or more of chloroform, dichloromethane, and tetrahydrofuran.

In any embodiment, the second organic solvent includes one or more of chlorobenzene, o-dichlorobenzene, toluene, o-xylene, anisole, 2-methylanisole, 2-chlorophenol, and 1,2,3,4-tetrahydronaphthalene.

In any embodiment, based on a total volume of the solvent, a volume fraction of the first organic solvent is 20% to 80%, and a volume fraction of the second organic solvent is 20% to 80%.

In any embodiment, based on a total mass of the solution, the mass fraction of the first additive is 0.2‰ to 1‰, the mass fraction of the second additive is 0.1‰ to 0.4‰, and the mass fraction of the organic electron transport material is 1.86% to 1.97%.

In any embodiment, based on a total mass of the solute, the mass fraction of the first additive is 1% to 5%, the mass fraction of the second additive is 0.5% to 2%, and the mass fraction of the organic electron transport material is 93% to 98.5%.

A third aspect of this application provides a photovoltaic module including the perovskite solar cell according to the first aspect of this application.

A fourth aspect of this application provides a photovoltaic system including the photovoltaic module according to the third aspect of this application.

A fifth aspect of this application provides an electric device including at least one of the perovskite solar cell according to the first aspect of this application and the photovoltaic module according to the third aspect of this application.

For the perovskite solar cell of this application, by adding a specific organic polymer as the first additive and specific quaternary ammonium salts and/or tertiary amine molecules as the second additive to the electron transport layer containing the organic electron transport material, the photoelectric conversion efficiency and stability of perovskite solar cells using organic electron transport materials as the electron transport layer can be effectively improved.

### BRIEF DESCRIPTION OF THE DRAWINGS

To more clearly illustrate the technical solutions of the embodiments of this application, the accompanying drawings required for use in the embodiments of this application will be briefly introduced below. Obviously, the accompanying drawings described below are merely some embodiments of this application, and for those of ordinary skill in the art, other drawings can be obtained based on these drawings without creative effort. In the drawings:
FIG. 1 is a schematic structural diagram of a perovskite solar cell according to an embodiment of this application; and
FIG. 2 is a schematic structural diagram of an electric device according to an embodiment of this application.

### Reference signs:

1. perovskite solar cell; 2. electric device; 11. transparent electrode layer; 12. hole transport layer; 13. perovskite layer; 14. electron transport layer; and 15. metal electrode.

### DETAILED DESCRIPTION OF EMBODIMENTS

Hereinafter, some embodiments disclosing a perovskite precursor solution, a perovskite thin film, a perovskite solar cell, and an electric device of this application will be described in detail with appropriate reference to the accompanying drawings. However, unnecessary detailed descriptions may be omitted. For example, detailed descriptions of well-known matters and repetitive descriptions of substantially identical structures may be omitted. This is to avoid unnecessarily prolonging the following description and to facilitate understanding by those skilled in the art. Furthermore, the accompanying drawings and the following description are provided for those skilled in the art to fully understand this application and are not intended to limit the subject matter recited in the claims.

The "range" disclosed in this application is defined in the form of a lower limit and an upper limit, and a given range is defined by selecting a lower limit and an upper limit, which define the boundaries of the particular range. Ranges defined in this manner may or may not include endpoints and may be arbitrarily combined, that is, any lower limit may be combined with any upper limit to form a range. For example, if ranges of 60 to 120 and 80 to 110 are listed for a particular parameter, it is understood that ranges of 60 to 110 and 80 to 120 are also contemplated. Additionally, if minimum range values of 1 and 2 are listed, and if maximum range values of 3, 4, and 5 are listed, the following ranges are all contemplatable: 1 to 3, 1 to 4, 1 to 5, 2 to 3, 2 to 4, and 2 to 5. In this application, unless otherwise specified, the numerical range "a to b" represents an abbreviated representation of any combination of real numbers between a and b, where a and b are both real numbers. For example, the numerical range "0 to 5" indicates that all real numbers between "0 to 5" inclusive have been listed herein, and "0 to 5" is merely an abbreviated representation of these numerical combinations. Additionally, when a parameter is expressed as an integer ≥2, it is equivalent to disclosing that the parameter is, for example, the integer 2, 3, 4, 5, 6, 7, 8, 9, 10, 11, or 12. For example, when a parameter is expressed as selected from the integers "2 to 10", it is equivalent to listing the integers 2, 3, 4, 5, 6, 7, 8, 9, and 10.

Unless otherwise specified, all embodiments and optional embodiments of this application may be combined with each other to form new technical solutions.

Unless otherwise specified, all steps of this application may be performed sequentially or randomly, preferably sequentially. For example, a method including steps (a) and (b) indicates that the method may include steps (a) and (b) performed sequentially, or may include steps (b) and (a) performed sequentially. For example, mentioning that the method may further include step (c) indicates that step (c) may be added to the method in any order, for example, the method may include steps (a), (b), and (c), or may include steps (a), (c), and (b), or may include steps (c), (a), and (b), and so on.

Unless otherwise specified, the terms "including" and "containing" mentioned in this application indicate open-ended or closed-ended. For example, "including" and "containing" may indicate that other components not listed may or may not be included or contained.

Unless otherwise specified, in this application, the term "or" is inclusive. For example, the phrase "A or B" means "A, B, or both A and B". More specifically, any of the following conditions satisfies the condition "A or B": A is true (or present) and B is false (or absent); A is false (or absent) and B is true (or present); or both A and B are true (or present).

In this application, unless otherwise specified, A (such as B) indicates that B is a non-limiting example of A, and it is understood that A is not limited to B.

As used in this application, terms such as "multiple" and "various", unless otherwise specified, refer to more than 2 or equal to 2 in quantity. For example, "one or more" means one or more than or equal to two.

As used herein, "combinations thereof", "any combinations thereof", "any combination modes thereof", and the like include all suitable combinations of any two or more than two items from the listed items.

As used herein, "suitable" in "suitable combination mode", "suitable mode", "any suitable mode", and the like is subject to the ability to implement the technical solution of this application.

As used herein, "preferred", "better", "more preferred", "preferable" only describe embodiments or examples with better effects, and it should be understood that they do not limit the protection scope of this application. If "preferred" appears multiple times in a technical solution, unless otherwise specified and without contradictions or mutual constraints, each "preferred" is independent.

As used in this application, "further", "still further", "particularly", and the like are used for description purposes to indicate differences in content, but should not be understood as limiting the protection scope of this application.

As used in this application, in "first aspect", "second aspect", "third aspect", "fourth aspect", and the like, the terms "first", "second", "third", "fourth", and the like are only used for description purposes and cannot be understood as indicating or implying relative importance or quantity, nor can they be understood as implicitly indicating the importance or quantity of the indicated technical features. Moreover, "first", "second", "third", "fourth", and the like only serve non-exhaustive enumeration description purposes, and it should be understood that they do not constitute a closed limitation on quantity.

As used in this application, the term "room temperature" generally refers to 4°C to 35°C, and may refer to 20°C±5°C. In some embodiments of this application, room temperature refers to 20°C to 30°C.

In this application, for units involving data ranges, if a unit is only attached after the right endpoint, it indicates that the units of the left endpoint and the right endpoint are the same. For example, 3 h to 5 h or 3 h to 5 h both indicate that the unit of the left endpoint "3" and the right endpoint "5" is h (hour).

The weights of the relevant components mentioned in the description of the embodiments of this application may not only refer to the specific content of the various component, but also represent the proportional relationship of the weights among the components. Therefore, as long as the content of the relevant components is scaled up or down according to the description of the embodiments of this application, it falls within the scope disclosed in the description of the embodiments of this application. Furthermore, the weight in the description of the embodiments of this application may be in units of mass known in the chemical field, such as µg, mg, g, and kg.

As used herein, unless otherwise specified, "alkyl" refers to a monovalent residue generated by the loss of one hydrogen atom from a saturated hydrocarbon containing primary (normal) carbon atoms, or secondary carbon atoms, or tertiary carbon atoms, or quaternary carbon atoms, or combinations thereof. Phrases containing this term, for example, "C₁-C₉ alkyl" refer to alkyl groups containing 1 to 9 carbon atoms, and each occurrence may independently be C₁ alkyl, C₂ alkyl, C₃ alkyl, C₄ alkyl, C₅ alkyl, C₆ alkyl, C₇ alkyl, Cs alkyl, or C₉ alkyl. Suitable examples include but are not limited to: methyl (Me, -CH₃), ethyl (Et, -CH₂CH₃), 1-propyl (n-Pr, n-propyl, -CH₂CH₂CH₃), 2-propyl (i-Pr, i-propyl, -CH(CH₃)₂), 1-butyl (n-Bu, n-butyl, -CH₂CH₂CH₂CH₃), 2-methyl-1-propyl (i-Bu, i-butyl, -CH₂CH(CH₃)₂), 2-butyl (s-Bu, s-butyl, -CH(CH₃)CH₂CH₃), 2-methyl-2-propyl (t-Bu, t-butyl, -C(CH₃)₃), 1-pentyl (n-pentyl, - CH₂CH₂CH₂CH₂CH₃), 2-pentyl (-CH(CH₃)CH₂CH₂CH₃), 3-pentyl (-CH(CH₂CH₃)₂), 2-methyl-2-butyl (-C(CH₃)₂CH₂CH₃), 3-methyl-2-butyl (-CH(CH₃)CH(CH₃)₂), 3-methyl-1-butyl (-CH₂CH₂CH(CH₃)₂), 2-methyl-1-butyl (-CH₂CH(CH₃)CH₂CH₃), 1-hexyl (-CH₂CH₂CH₂CH₂CH₂CH₃), 2-hexyl (-CH(CH₃)CH₂CH₂CH₂CH₃), 3-hexyl (-CH(CH₂CH₃)(CH₂CH₂CH₃)), 2-methyl-2-pentyl (-C(CH₃)₂CH₂CH₂CH₃), 3-methyl-2-pentyl (-CH(CH₃)CH(CH₃)CH₂CH₃), 4-methyl-2-pentyl (-CH(CH₃)CH₂CH(CH₃)₂), 3-methyl-3-pentyl (-C(CH₃)(CH₂CH₃)₂), 2-methyl-3-pentyl (-CH(CH₂CH₃)CH(CH₃)₂), 2,3-dimethyl-2-butyl (-C(CH₃)₂CH(CH₃)₂), 3,3-dimethyl-2-butyl (-CH(CH₃)C(CH₃)₃), and octyl (-(CH₂)₇CH₃).

As used herein, unless otherwise specified, "heteroalkyl" refers to alkyl in which at least one carbon atom is replaced by a non-carbon atom, and the non-carbon atom may be N atom, O atom, S atom, P atom, or the like. The following takes O, N, S as examples for illustration. For example, if a carbon atom in alkyl connected to an adjacent group is replaced by a non-carbon atom O, N, or S, the resulting heteroalkyl groups are alkoxy (such as -OCH₃), amino (such as -NHCH₃ or -N(CH₃)₂), or thioalkyl (such as -SCH₃). If a carbon atom in alkyl not directly connected to an adjacent group is replaced by a non-carbon atom O, N, or S, the resulting heteroalkyl groups are alkoxyalkyl (such as -CH₂CH₂-O-CH₃), alkylaminoalkyl (such as -CH₂NHCH₃ and -CH₂N(CH₃)₂), or alkylthioalkyl (such as -CH₂-S-CH₃). If the terminal carbon atom of alkyl is replaced by a non-carbon atom, the resulting heteroalkyl groups may be hydroxyalkyl (such as -CH₂CH₂-OH), aminoalkyl (such as -CH₂NH₂), or mercaptoamino (such as -CH₂CH₂-SH). Phrases containing the term "heteroalkyl", for example, "C₁-C₉ heteroalkyl" or "C₁₋₉ heteroalkyl", refer to heteroalkyl groups containing 1 to 9 carbon atoms, and each occurrence may independently be C₁ heteroalkyl, C₂ heteroalkyl, C₃ heteroalkyl, C₄ heteroalkyl, C₅ heteroalkyl, C₆ heteroalkyl, C₇ heteroalkyl, C₈ heteroalkyl, or C₉ heteroalkyl.

As used herein, unless otherwise specified, "cycloalkyl" and "non-aromatic cyclic hydrocarbyl" have the same meaning, referring to a monovalent residue generated by the loss of one hydrogen atom from a ring in a non-aromatic hydrocarbon (saturated or unsaturated hydrocarbon), that is, forming a monovalent attachment site directly on the ring. Cycloalkyl derived from non-aromatic saturated hydrocarbons may be denoted as saturated cycloalkyl, and cycloalkyl derived from non-aromatic unsaturated hydrocarbons may be denoted as unsaturated cycloalkyl. Cycloalkyl may be monocyclic, spirocyclic, or bridged. Phrases containing this term, for example, "C₃-C₉ cycloalkyl" or "C₃₋₉ cycloalkyl", refer to cycloalkyl groups containing 3 to 9 carbon atoms, and each occurrence may independently be C₃ cycloalkyl, C₄ cycloalkyl, C₅ cycloalkyl, C₆ cycloalkyl, C₇ cycloalkyl, C₈ cycloalkyl, or C₉ cycloalkyl. Suitable examples include but are not limited to: cyclopropyl 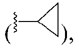 cyclobutyl 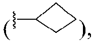 cyclopentyl 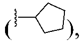 cyclohexyl 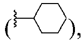 and cycloheptyl. Additionally, "cycloalkyl" may also contain one or more double bonds, and representative examples of cycloalkyl containing double bonds include cyclopentenyl (including but not limited to 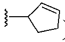 ), cyclohexenyl (including but not limited to 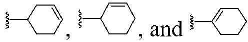 ), cyclohexadienyl (including but not limited to 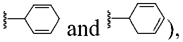 cyclopentadienyl (including but not limited to 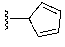 ), and cyclobutadienyl (including but not limited to 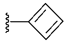 ).

As used herein, unless otherwise specified, "heterocycloalkyl" refers to cycloalkyl in which at least one carbon atom is replaced by a non-carbon atom, and the non-carbon atom may be N atom, O atom, S atom, or the like, and may be saturated or partially unsaturated. Phrases containing this term, for example, "C₄-C₉ heterocycloalkyl", refer to heterocycloalkyl groups containing 4 to 9 carbon atoms, and each occurrence may independently be C₄ heteroalkyl, C₅ heteroalkyl, C₆ heteroalkyl, C₇ heteroalkyl, C₈ heteroalkyl, or C₉ heteroalkyl. Suitable examples include but are not limited to: dihydropyridyl, tetrahydropyridyl (piperidinyl), tetrahydrothienyl, sulfoxidized tetrahydrothienyl, tetrahydrofuranyl, tetrahydroquinolinyl, tetrahydroisoquinolinyl, and dihydroindolyl.

As used herein, unless otherwise specified, "aryl" refers to an aromatic hydrocarbyl group derived by the loss of one hydrogen atom from an aromatic ring hydrocarbon compound, that is, forming a monovalent attachment site directly on the ring, and may be monocyclic aryl, fused-ring aryl, or polycyclic aryl, where for polycyclic rings, at least one is an aromatic ring system. For example, "C₆-C₁₀ aryl" refers to aryl groups containing 6 to 10 carbon atoms, and each occurrence may independently be C₆ aryl, C₈ aryl, C₉ aryl, or C₁₀ aryl. Further for example, "C₆-C₂₀ aryl" refers to aryl groups containing 6 to 20 carbon atoms, and each occurrence may independently be but not limited to C₆ aryl (such as phenyl), C₆ aryl tetrahydro quinolinyl (such as benzocyclobutenyl), C₈ aryl (such as benzocyclobutenyl), C₉ aryl (such as indenyl), C₁₀ aryl (such as naphthyl), C₁₂ aryl (such as acenaphthenyl, biphenyl), C₁₃ aryl (such as fluorenyl), C₁₄ aryl (such as anthryl, phenanthryl), C₁₈ aryl (such as triphenylenyl), or C₂₀ aryl (such as perylenyl). Suitable examples of aromatic ring hydrocarbon compounds include but are not limited to: benzene, benzocyclobutene, biphenyl, indene, naphthalene, acenaphthene, fluorene, anthracene, phenanthrene, triphenylene, perylene, and derivatives thereof.

As used herein, unless otherwise specified, "heteroaryl" is a heterocyclic group having aromaticity, and may be a monovalent group formed by replacing at least one carbon atom in aryl with a non-carbon atom, or may be a monovalent group formed by replacing at least one carbon atom in cyclopentadienyl with a non-carbon atom, and the non-carbon atom may be but not limited to N atom, O atom, and S atom. For example, "C₁-C₁₀ heteroaryl" refers to heteroaryl groups containing 1 to 10 carbon atoms, and each occurrence may independently be C₁ heteroaryl (such as tetrazolyl), C₂ heteroaryl (such as triazolyl, oxadiazolyl), C₃ heteroaryl (such as imidazolyl), C₄ heteroaryl (such as furanyl), C₅ heteroaryl (such as pyridyl), C₆ heteroaryl, C₇ heteroaryl (such as benzimidazolyl), C₈ heteroaryl (such as indolyl), C₉ heteroaryl (such as quinolyl), or C₁₀ heteroaryl (such as pyrrolopyridyl). Further for example, "C₃-C₂₀ heteroaryl" refers to heteroaryl groups containing 3 to 20 carbon atoms, and each occurrence may independently be but not limited to C₂ heteroaryl, C₃ heteroaryl, C₄ heteroaryl, C₅ heteroaryl, C₆ heteroaryl, C₈ heteroaryl, C₉ heteroaryl, C₁₀ heteroaryl, C₁₂ heteroaryl, C₁₃ heteroaryl, C₁₄ heteroaryl, C₁₈ heteroaryl, or C₂₀ heteroaryl. Suitable examples include but are not limited to heteroaryl groups derived from the following heteroaromatic rings (carbon atom numbers marked in parentheses): furan (C₄), benzofuran (C₈), thiophene (C₄), benzothiophene (C₈), pyrrole (C₄), pyrazole (C₃), triazole (C₂), imidazole (C₃), oxazole (C₃), oxadiazole (C₂), thiazole (C₃), tetrazole (C₁), indole (C₈), carbazole (C₁₂), pyrroloimidazole (C₈), pyrrolopyrrole (C₆), thienopyrrole (C₆), thienothiophene (C₆), furopyrrole (C₆), furofuran (C₆), thienofuran (C₆), thienopyridine (C₇), furopyridine (C₇), benzoxazole (C₇), benzisoxazole (C₇), benzothiazole (C₇), benzisothiazole (C₇), benzimidazole (C₇), pyridine (C₈), pyrazine (C₄), pyridazine (C₄), pyrimidine (C₄), triazine (C₃), quinoline (C₉), isoquinoline (C₉), diazanaphthalene (C₈, such as phthalazine), quinoxaline (C₈), phenanthridine (C₁₃), acridine (C₁₁), quinazoline (C₈), and quinazolinone (Cs).

As used herein, unless otherwise specified, "alkylene" refers to a hydrocarbyl group with two monovalent group centers formed by removing two hydrogen atoms from alkane (or by further losing one hydrogen atom from alkyl), which may be saturated branched alkylene or saturated linear alkylene. For example, "C₁-C₉ alkylene" refers to alkylene with the alkyl portion containing 1 to 9 carbon atoms, and each occurrence may independently be C₁ alkylene, C₂ alkylene, C₃ alkylene, C₄ alkylene, C₈ alkylene, C₆ alkylene, C₇ alkylene, C₈ alkylene, or C₉ alkylene. Suitable examples include but are not limited to: methylene (-CH₂-), 1,1-ethyl (-CH(CH₃)-), 1,2-ethyl (-CH₂CH₂-), 1,1-propyl (-CH(CH₂CH₃)-), 1,2-propyl (-CH₂CH(CH₃)-), 1,3-propyl (-CH₂CH₂CH₂-), and 1,4-butyl (-CH₂CH₂CH₂CH₂-).

As used herein, unless otherwise specified, "halogen" or "halo" refers to F, Cl, Br, or I.

As used herein, unless otherwise specified, "amino" may be primary amino (-NH₂), secondary amino (>NH), tertiary amino (>N-), or quaternary amino (>N+<),

As used herein, unless otherwise specified, hydroxy is -OH, carboxyl is -COOH, cyano is -CN, hydrazino is -NHNH2, sulfinic acid is -S(=O)OH, phosphinic acid is (*-)₂P(=O)OH, sulfonic acid is -S(=O)₂OH, phosphoric acid is (*-)P(=O)(OH)₂, and boronic acid is (*-)B(OH)₂; where * in phosphinic acid indicates attachment to carbon atom or H and at least one attachment to carbon atom, * in phosphoric acid indicates attachment to carbon atom, and * in boronic acid indicates attachment to carbon atom.

Currently, the photoelectric conversion efficiency of perovskite solar cells using organic electron transport layer materials still needs further improvement, and the stability of such cells is relatively poor, limiting the industrialized large-scale production of perovskite solar cells using organic electron transport layers. This application proposes a perovskite solar cell that, by adjusting the material composition for forming the organic electron transport layer, can effectively improve the photoelectric conversion efficiency and stability of the perovskite solar cell.

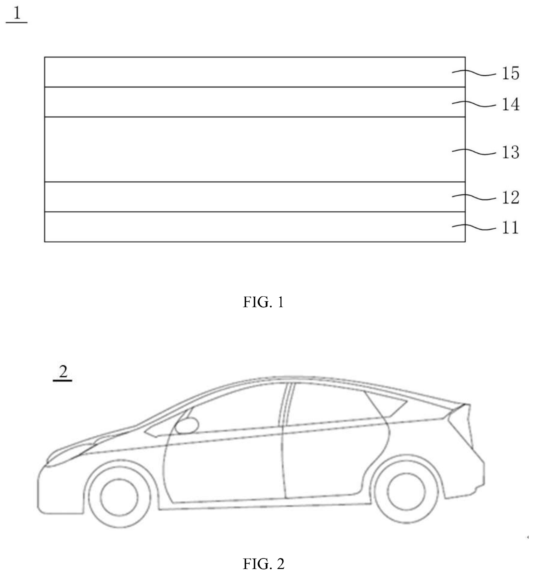

Referring to FIG. 1, an embodiment of this application provides an invertedstructure perovskite solar cell 1. The perovskite solar cell 1 includes a transparent electrode layer 11 and, a hole transport layer 12, a perovskite layer 13, an electron transport layer 14, and a metal electrode 15 sequentially disposed on the transparent electrode layer 11.

The electron transport layer 14 includes an organic electron transport material, a first additive, and a second additive; where the first additive includes one or more of polymethyl methacrylate, methacrylic acid-methyl methacrylate copolymer, 4-vinylpyridine-styrene copolymer, polyacrylonitrile, and poly(4-vinylpyridine); and
the second additive includes one or more of the following compound of formula I and compound of formula II: 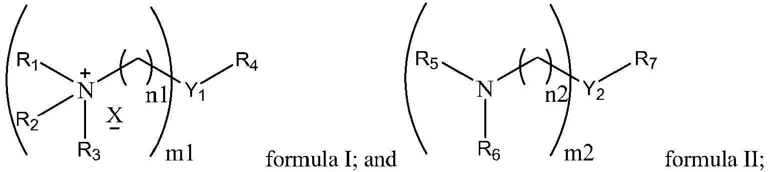
where R₁, R₂, R₃, R₅, and R₆ are each independently selected from C₁-C₄ alkyl; n1 and n2 are each independently an integer from 1 to 6; m1 and m2 are each independently an integer from 1 to 4; R₄ and R₇ are each independently selected from C₁-C₅ alkyl, C₁-C₅ alkoxy, C₁-C₅ alkylthio, aryl, halogen, carboxyl, cyano, or absent; X is one or more of Cl, Br, I, BF₄, PF₆, and TFSI; and Y₁ and Y₂ are each independently selected from any one of CH₂, NH, O, and S, or absent. The "absent" means the group is H.

In conventional perovskite solar cells 1 using organic electron transport layer materials, due to the poor conductivity of organic electron transport materials, the photovoltaic performance of the perovskite solar cell 1 is limited, restricting the photoelectric conversion efficiency of the cell. Moreover, the dispersibility of organic electron transport materials in solvents is not good enough, with severe agglomeration, affecting the film uniformity of the electron transport layer 14, resulting in poor stability of cells using organic electron transport materials as the electron transport layer 14. The above factors hinder the large-scale industrial application of perovskite solar cells 1 using organic electron transport materials as the electron transport layer 14.

In the above perovskite solar cell 1 of this application, a specific organic polymer as the first additive is added to the electron transport layer 14 containing the organic electron transport material, and specific quaternary ammonium salts and/or tertiary amine molecules as the second additive are added. The introduction of the above organic polymer can improve the dispersibility of the organic electron transport material in the solution for forming the electron transport layer 14, reduce agglomeration of the organic electron transport material, and improve the film uniformity of the electron transport layer 14, thereby enhancing the photoelectric conversion efficiency of the device; the introduction of the above quaternary ammonium salts can significantly improve the film conductivity of the electron transport layer 14, thereby improving the photoelectric conversion efficiency of the perovskite solar cell; and the introduction of the above tertiary amine molecules can, through the synergistic effect of N atoms with the electron transport layer 14, enhance the binding force with transport layer molecules, improve molecular orientation, and increase the electron mobility of the electron transport layer 14.

Moreover, the hydrophobic functional groups in the above organic polymer can reduce channels for water molecules to penetrate into the electron transport layer 14, alleviating the reaction of water with perovskite through the electron transport layer 14, thereby improving device stability; the above quaternary ammonium salts and tertiary amine molecules can, during the molecular crystallization of the electron transport layer 14, form a passivation layer at the perovskite interface, thereby reducing the diffusion of perovskite ions, suppress perovskite decomposition, and improve device stability. Through the synergistic effect of the above specific first additive and second additive, the photoelectric conversion efficiency and stability of perovskite solar cells 1 employing organic electron transport materials can be effectively improved.

It is understood that the electron transport layer 14 of the perovskite solar cell 1 may include only the organic electron transport material, the first additive organic polymer, and the second additive quaternary ammonium salts; or may include only the organic electron transport material, the first additive organic polymer, and the second additive tertiary amine molecules; or may include all of the organic electron transport material, the first additive organic polymer, the second additive quaternary ammonium salts, and the second additive tertiary amine molecules.

It can be understood that R₁, R₂, R₃, R₅, and R₆ in the above compounds of formula I and formula II may each independently be methyl, ethyl, n-propyl, n-butyl, isopropyl, isobutyl, tert-butyl, or the like; n1 and n2 may each independently be 1, 2, 3, 4, or 5; and m1 and m2 may each independently be 1, 2, 3, or 4.

In some of these embodiments, based on a total mass of the electron transport layer 14, a mass fraction of the first additive is 1% to 5%, a mass fraction of the second additive is 0.5% to 2%, and a mass fraction of the organic electron transport material is 93% to 98.5%. When the amounts of the first additive, second additive, and organic electron transport material in the electron transport layer 14 fall within the above ranges, the photoelectric conversion efficiency and stability of the perovskite solar cell 1 can be further improved.

In some of these embodiments, the second additive includes the compound of formula I and the compound of formula II, and a mass ratio of the compound of formula I to the compound of formula II is (0.5 to 2):1. In this way, two types of second additives, the compound of formula I and the compound of formula II, are both used in the electron transport layer 14, and the mass ratio of the compound of formula I to the compound of formula II is controlled within (0.5 to 2):1. Through the synergistic effect of specific amounts of second additive quaternary ammonium salts, second additive tertiary amine molecules, first additive organic polymer, and organic electron transport material, the photoelectric conversion efficiency and stability of the perovskite solar cell 1 can be further improved.

In some of these embodiments, the compound of formula I is one or more of tetrabutylammonium tetrafluoroborate, hexamethylenediammonium iodide, and dodecyltrimethylammonium bromide; the compound of formula II is one or more of 1,7-bis(dimethylamino)heptane, tris(dimethylaminopropyl)amine, and 9,9-bis[3-(dimethylamino)propyl]fluorene.

In some of these embodiments, a thickness of the electron transport layer is 25 nm to 45 nm. It is understood that the thickness of the electron transport layer may be but not limited to 25 nm, 28 nm, 30 nm, 32 nm, 35 nm, 38 nm, 40 nm, 42 nm, or 45 nm.

In some of these embodiments, the organic electron transport material includes one or more of fullerene derivatives, naphthalene diimide and derivatives thereof, and perylene diimide and derivatives thereof. The fullerene derivative may be PCBM ([6,6]-phenyl-C₆₁-butyric acid methyl ester), [6,6]-phenyl-C71-butyric acid methyl ester (PC71BM), C₆₀-PDI (C₆₀-perylene diimide), or the like

In some of these embodiments, the transparent conductive layer 11 may be a transparent conductive oxide, such as FTO (fluorine-doped tin oxide, SnO₂:F), ITO (tin-doped indium oxide), BZO (boron-doped zinc oxide), AZO (aluminum zinc oxide), IZO (indium zinc oxide), and the above transparent oxides may be laid on a substrate, where the substrate may be a rigid substrate or a flexible substrate. In some embodiments, the substrate may be transparent glass.

The hole transport layer 12 may use hole transport materials commonly used in the art. In a specific example, the hole transport layer 12 uses PTAA (poly(triarylamine)), Spiro-OMeTAD (tetrakis(N,N-p-methoxyphenylamino)-9,9'-spirobifluorene), or Me-4PACz ([4-(3,6-dimethyl-9H-carbazol-9-yl)butyl]phosphonic acid).

The perovskite layer 13 may use perovskite components commonly used in the art, with the chemical formula of the perovskite component satisfying ABX₃ or A₂CDX₆; where A is an inorganic monovalent cation or organic monovalent cation or a mixture thereof, and A includes one or more of FA⁺, MA⁺, Cs⁺, Rb⁺, K⁺, DMA⁺, EA⁺, and GA⁺; B is an inorganic divalent metal cation, and B includes one or more of Pb²⁺, Ge²⁺, Cd²⁺, Sb²⁺, Zn²⁺, Mn²⁺, and Ca²⁺; C is a noble metal cation, commonly Ag⁺; D is a heavy metal or rare earth metal trivalent cation, which may be at least one of bismuth cation Bi³⁺, antimony cation Sb³⁺, and indium cation In³⁺; and X is oxygen or halogen element or pseudohalogen element, and X includes one or more of I⁻, Br⁻, Cl⁻, SCN⁻, HCOO⁻, CH₃COO⁻, CF₃COO⁻, CH₃SO₃⁻, CF₃SO₃⁻, and CN⁻. In a specific example, the perovskite component is Cs_{0.05}MA_{0.1}FA_{0.85}PbI₃; where MA is methylammonium, and FA is formamidinium.

The metal electrode 15 may use electrodes commonly used in the art, such as Au, Ag, Cu, Al, or Pt. In a specific example, the metal electrode 15 is an Ag electrode.

An embodiment of this application provides a method for preparing the above perovskite solar cell 1, including the following steps S100 to S500.

Step S100: Provide the transparent electrode layer 11.

The transparent electrode layer 11 serves as a device substrate. Specifically, the transparent electrode layer 11 may be FTO glass. Before preparing the hole transport layer 12 on the transparent electrode layer 11, UV cleaning treatment is performed on the transparent electrode layer 11 to remove impurities on the surface of the transparent electrode layer 11.

In a specific example, the transparent electrode layer 11 is FTO glass.

Step S200: Form the hole transport layer 12 on the transparent electrode layer 11.

A solution containing a hole transport material is spin-coated on one surface of the transparent electrode layer 11 using a spin-coating process, followed by annealing to form the hole transport layer 12.

The spin-coating process parameters (such as spin-coating speed and spin-coating time) during the preparation of the hole transport layer 12 may be specifically set according to the actual situation such as the thickness of the hole transport layer 12 to be prepared. Similarly, the annealing temperature may also be set according to actual production conditions.

It can be understood that the material for forming the hole transport layer 12 may be conventional hole transport materials in the art.

In a specific example, the hole transport material is PTAA, with a spin-coating speed of 5000 rpm/s, a spin-coating time of 30s, and an annealing temperature of 100°C.

Step S300: Form the perovskite layer 13 on the hole transport layer 12.

A solution containing a perovskite component is spin-coated on the surface of the hole transport layer 12 away from the transparent electrode layer 11 using a spin-coating process, and annealed to form the perovskite layer 13.

The spin-coating process parameters (such as spin-coating speed, spin-coating acceleration, and spin-coating time) during the preparation of the perovskite layer 13 may be specifically set according to the actual situation such as the thickness of the perovskite layer 13 to be prepared. The annealing temperature may also be set according to actual production conditions.

It can be understood that the perovskite layer 13 may use perovskite components commonly used in the art.

In a specific example, the perovskite component is Cs_{0.05}MA_{0.1}FA_{0.85}PbI₃, with a spin-coating speed of 5000 rpm/s, a spin-coating acceleration of 2000 rpm/s, a spin-coating time of 30s, and an annealing temperature of 100°C.

Step S400: Form the electron transport layer 14 on the perovskite layer 13.

A solution containing the organic electron transport material, the first additive, and the second additive is spin-coated on the surface of the perovskite layer 13 away from the hole transport layer 12 using a spin-coating process, and the electron transport layer 14 can be formed without annealing. The solution includes a solvent and a solute dispersed in the solvent, where the solute includes the organic electron transport material, the first additive, and the second additive. The types of the organic electron transport material, first additive, and second additive in the electron transport layer 14 are as described above and will not be repeated herein.

It can be understood that the spin-coating process parameters (such as spin-coating speed and spin-coating time) during the preparation of the electron transport layer 14 may be specifically set according to the actual situation such as the thickness of the electron transport layer 14 to be prepared. The electron transport layer 14 may use organic electron transport materials commonly used in the art.

In a specific example, the spin-coating speed is 2000 rpm/s, the spin-coating time is 30s, and the organic electron transport material is PCBM.

In some embodiments, the solvent in the solution for forming the electron transport layer 14 includes a first organic solvent and a second organic solvent. The first organic solvent is a low-boiling-point solvent with a boiling point of 38°C to 70°C; and the second organic solvent is a high-boiling-point solvent with a boiling point of 110°C to 210°C.

In some embodiments, the first organic solvent includes one or more of chloroform (boiling point about 61°C), dichloromethane (boiling point about 39.75°C), and tetrahydrofuran (boiling point about 66°C). The second organic solvent includes one or more of chlorobenzene (boiling point about 132.2°C), o-dichlorobenzene (boiling point about 180.4°C), toluene (boiling point about 110.6°C), o-xylene (boiling point about 144.4°C), anisole (boiling point about 153.8°C), 2-methylanisole (boiling point about 170°C), 2-chlorophenol (boiling point about 174°C), and 1,2,3,4-tetrahydronaphthalene (boiling point about 207.2°C).

In some of these embodiments, based on a total volume of the solvent, a volume fraction of the first organic solvent is 20% to 80%, and a volume fraction of the second organic solvent is 20% to 80%. It is understood that the volume fraction of the first organic solvent may be but not limited to 20%, 30%, 40%, 50%, 60%, 70%, and 80%; correspondingly, the volume fraction of the second organic solvent may be but not limited to 80%, 70%, 60%, 50%, 40%, 30%, and 20%. In a specific example, the volume ratio of the first organic solvent to the second organic solvent is 1:1, that is, the high-boiling-point solvent and the low-boiling-point solvent are mixed in equal volumes, with a volume fraction of 50% each.

In some of these embodiments, in the solution for forming the electron transport layer 14, the mass fraction of the first additive is 0.2‰ to 1‰, the mass fraction of the second additive is 0.1‰ to 0.4‰, and the mass fraction of the organic electron transport material is 1.86% to 1.97%.

In some of these embodiments, in the solute for forming the electron transport layer 14, the mass fraction of the first additive is 1% to 5%, the mass fraction of the second additive is 0.5% to 2%, and the mass fraction of the organic electron transport material is 93% to 98.5%.

Step S500: Form the metal electrode 15 on the electron transport layer 14.

The metal electrode 15 is prepared on the electron transport layer 14 using a thermal evaporation process, where an evaporation rate of the thermal evaporation process may be set according to actual needs; and the material of the metal electrode 15 may also use electrode materials commonly used in the art.

In a specific example, when the evaporation rate is 0.2 Å/s, a metal Ag electrode with a thickness of 110 nm is formed.

The method for preparing the perovskite solar cell 1 of this application uses a spin-coating process to spin-coat a solution containing the organic electron transport material, the first additive, and the second additive onto the perovskite layer 13 to prepare the electron transport layer 14. By using the specific first additive and second additive of this application in the electron transport layer 14, the photoelectric conversion efficiency and stability of the perovskite solar cell 1 can be effectively improved.

Further, a mixed solvent including the first organic solvent and the second organic solvent is used, where the first organic solvent is a low-boiling-point solvent and the second organic solvent is a high-boiling-point solvent, and mixing the first organic solvent and the second organic solvent in a specific volume ratio; and the organic electron transport material, the first additive, and the second additive are then dispersed in this mixed solvent system. In view of the differences in boiling points and viscosities (generally, high-boiling-point solvents have higher viscosities, low-boiling-point solvents have lower viscosities) of the first organic solvent and the second organic solvent, by regulating the volume ratio of different solvents, the crystallization sequence and uniformity of the organic electron transport material molecules, the first additive, and the second additive can be optimized, and molecular orientation can be guided. This can enhance the film quality and conductivity of the electron transport layer 14, and improve the photoelectric conversion efficiency and stability of the perovskite solar cell 1.

An embodiment of this application provides a photovoltaic module including the above perovskite solar cell of this application. The photovoltaic module of this application, by using the perovskite solar cell of this application, has high photoelectric conversion efficiency and good stability.

The above photovoltaic module includes one or more perovskite solar cells, the quantity of which may be selected according to specific application scenarios. Further, the above photovoltaic module includes multiple perovskite solar cells, and the multiple perovskite solar cells are connected in series or parallel to form a solar cell string.

**In** some of these embodiments, the above photovoltaic module further includes a photovoltaic glass layer, an adhesive layer, and a backsheet.

The adhesive layer is provided on each of two surfaces of the solar cell string, a backsheet is provided on a surface of one adhesive layer away from the solar cell string, and a photovoltaic glass layer is provided on a surface of the other adhesive layer away from the solar cell string.

The photovoltaic glass layer and the backsheet are used to protect the perovskite solar cell, and have sealing, insulating, and waterproof functions; and the adhesive layer serves to bond the photovoltaic glass layer to the solar cell string and bond the backsheet to the solar cell string.

Optionally, the material of the photovoltaic glass layer is tempered glass, the material of the backsheet is TPT (polyvinyl fluoride) or TPE (thermoplastic elastomer), and the material of the adhesive layer is EVA (ethylene-vinyl acetate copolymer).

Further, the above photovoltaic module further includes a junction box and an outer frame.

The junction box is configured to protect the power generation system of the entire photovoltaic module, and is equivalent to a current transfer station; and when a solar cell string short-circuits, the junction box automatically disconnects the short-circuited solar cell string.

The outer frame can support and protect the entire photovoltaic module, and the frame may be aluminum alloy material with excellent strength and corrosion resistance.

Further, silicone is used to bond and seal the connections between the frame and other parts of the photovoltaic module. The photovoltaic module can convert solar energy into electrical energy, or send the solar energy to a battery for storage, or drive a load to work.

**In** some of these embodiments, the above photovoltaic module is a solar panel.

An embodiment of this application provides a photovoltaic system including the above photovoltaic module.

The photovoltaic system utilizes the perovskite solar cell in the above photovoltaic module to directly convert solar radiation energy into electrical energy, featuring high efficiency and good stability. Further, the above photovoltaic system is a photovoltaic power generation system.

The photovoltaic module is the core part of the photovoltaic power generation system. The above photovoltaic system includes one or more photovoltaic modules, the quantity of which may be selected according to specific application scenarios. Further, when the above photovoltaic system includes multiple photovoltaic modules, the multiple photovoltaic modules form a photovoltaic array.

The above photovoltaic system may be an independent photovoltaic power generation system or a grid-connected photovoltaic power generation system.

The independent photovoltaic power generation system includes a photovoltaic array, a battery pack, a charge controller, a power electronic converter (inverter), a load, or the like. The working principle of the independent photovoltaic power generation system is that solar radiation energy is first converted into electrical energy through the photovoltaic array, which is then transformed by the power electronic converter to supply power to the load; meanwhile, excess electrical energy is stored in the energy storage device in the form of chemical energy through the charge controller; thus, when sunlight is inadequate, the energy stored in the battery can be inverted by the power electronic inverter, filtered, and boosted via a power frequency transformer to become 220 V, 50 Hz alternating-current power for alternating-current loads.

The grid-connected photovoltaic power generation system includes a photovoltaic array, a high-frequency DC/DC boost circuit, a power electronic converter (inverter), and a system monitor. The working principle of the grid-connected photovoltaic power generation system is that solar radiation energy is converted through the photovoltaic array, then transformed into high-voltage direct current by high-frequency direct-current conversion, and then inverted by the power electronic inverter to output sinusoidal alternating current to the grid with the same frequency and phase as the grid voltage.

The above two photovoltaic power generation systems have their own characteristics and may be selected according to specific application scenarios.

Referring to FIG. 2, an embodiment of this application provides an electric device 2 including the above perovskite solar cell of this application.

In some embodiments, the electric device 2 is a common device incorporating the solar cell of this application, such as those in the communications, transportation, agriculture, or lighting fields. The electric device 2 may include, for example, satellites, communication equipment, traffic signal lights, lighthouses, wireless telephone booths, monitoring equipment in the oil drilling field, power systems, camping lights, electric vehicles, electronic device chargers, and building curtain walls.

Embodiments of this application will be described below. The embodiments described below are exemplary and are merely intended to illustrate this application, and should not be construed as limiting this application. Where specific techniques or conditions are not specified in the embodiments, they are carried out according to techniques or conditions described in the literature in the art or according to the product specification. Reagents or instruments without specified manufacturers are conventional products available commercially.

### I. Perovskite solar cell

### Example 1:

### (1) Transparent electrode layer

FTO glass was UV cleaned and used as the transparent electrode layer.

### (2) Preparation of hole transport layer

A solution containing the hole transport material PTAA was spin-coated on the transparent electrode layer and annealed to form the hole transport layer. The spin-coating speed was 5000 rpm/s, the spin-coating time was 30s, the annealing temperature was 100°C, the annealing time was 10 min, and the thickness of the hole transport layer was 15 nm.

### (3) Preparation of perovskite layer

A solution containing perovskite component raw materials was spin-coated on the hole transport layer and annealed to form the perovskite layer. The spin-coating speed was 5000 rpm/s, the spin-coating acceleration was 2000 rpm/s, the spin-coating time was 30s, the annealing temperature was 100°C, the annealing time was 15 min, the perovskite component was Cs_{0.05}MA_{0.1}FA_{0.85}PbI₃, and the thickness of the perovskite layer was 600 nm.

### (4) Preparation of electron transport layer

The organic electron transport material PCBM, the first additive polymethyl methacrylate, and the second additive tetrabutylammonium tetrafluoroborate were dispersed in a mixed solvent to prepare an electron transport layer solution. In the electron transport layer solution, the mixed solvent was 2-methylanisole and chloroform in a volume ratio of 1:1.

The above electron transport layer solution was spin-coated on the perovskite layer, and the solvent was removed to form the electron transport layer. The spin-coating speed was 2000 rpm/s, and the spin-coating time was 30s. In the electron transport layer, the mass fraction of PCBM was 94%, the mass fraction of polymethyl methacrylate was 5%, and the mass fraction of the second additive tetrabutylammonium tetrafluoroborate was 1%. The thickness of the electron transport layer was 40 nm.

### (5) Preparation of metal electrode

A metal Ag electrode was formed on the electron transport layer using a thermal evaporation process. The evaporation rate was 0.2 Å/s, and the thickness of the metal Ag electrode was 110 nm.

### Example 2:

This example was basically the same as Example 1, with the only difference being the type of the first additive. In this example, the first additive was methacrylic acid-methyl methacrylate copolymer.

### Example 3:

This example was basically the same as Example 1, with the only difference being the type of the first additive. In this example, the first additive was poly(4-vinylpyridine).

### Example 4:

This example was basically the same as Example 1, with the only difference being the type of the first additive. In this example, the first additive was 4-vinylpyridine-styrene copolymer.

### Example 5:

This example was basically the same as Example 1, with the only difference being the type of the second additive tertiary amine molecules. In this example, the second additive was tris(dimethylaminoethyl)amine, CAS No.: 33527-91-2.

### Example 6:

This example was basically the same as Example 1, with the only difference being the type of the second additive tertiary amine molecules. In this example, the second additive was 1,7-bis(dimethylamino)heptane, CAS No.: 29333-99-1.

### Example 7:

This example was basically the same as Example 1, with the only difference being the type of the second additive tertiary amine molecules. In this example, the second additive was 9,9-bis[3-(dimethylamino)propyl]fluorene, CAS No.: 1821313-63-6.

### Example 8:

This example was basically the same as Example 1, with the only difference being the type of the second additive. In this example, the second additive was a quaternary ammonium salt additive represented by formula I. Specifically, the second additive was hexamethylenediammonium iodide, CAS No.: 870-62-2.

### Example 9:

This example was basically the same as Example 1, with the only difference being the type of the second additive. In this example, the second additive was a quaternary ammonium salt additive represented by formula I. Specifically, the second additive was dodecyltrimethylammonium bromide, CAS No.: 1119-94-4.

### Example 10:

This example was basically the same as Example 1, with the only difference being the type of the second additive. In this example, the second additive was a mixture of a quaternary ammonium salt additive represented by formula I and a tertiary amine molecule additive represented by formula II. Specifically, the second additive was a mixture of tetrabutylammonium tetrafluoroborate (CAS No.: 429-42-5) and tris(dimethylaminoethyl)amine; and in the electron transport layer, the mass fraction of the quaternary ammonium salt additive was 1%, and the mass fraction of the tertiary amine molecule additive was 1%.

### Example 11:

This example was basically the same as Example 1, with the only difference being the type of the organic electron transport material. In this example, the organic electron transport material was naphthalene diimide.

### Example 12:

This example was basically the same as Example 1, with the only difference being the type of the organic electron transport material. In this example, the organic electron transport material was perylene diimide.

### Example 13:

This example was basically the same as Example 1, with the only difference being the mass fractions of the organic electron transport material, first additive, and second additive in the electron transport layer. In this example, the mass fraction of PCBM in the electron transport layer was 98%, the mass fraction of polymethyl methacrylate was 1%, and the mass fraction of the second additive tetrabutylammonium tetrafluoroborate was 1%.

### Example 14:

This example was basically the same as Example 1, with the only difference being the mixed solvent used in the solution for forming the electron transport layer. In this example, the mixed solvent was chlorobenzene and dichloromethane in a volume ratio of 1:2.

### Comparative Example 1:

This comparative example was basically the same as Example 1, with the only difference being that the first additive and second additive were not used in the electron transport layer.

### Comparative Example 2:

This comparative example was basically the same as Example 1, with the only difference being the type of the polymer additive in the electron transport layer. In this comparative example, the polymer additive was polyethylene.

### Comparative Example 3:

This comparative example was basically the same as Example 1, with the only difference being the type of the second additive in the electron transport layer. In this comparative example, the second additive was tris(3-aminopropyl)amine, CAS No.: 4963-47-7.

### II. Performance measurement of solar cells

### (1) Photoelectric conversion efficiency test

At 25°C, the perovskite solar cell was placed under sunlight using a test fixture, at a light power density of 100 mW/cm². Specifically, the test fixture and Keithley 2400 digital source meter were connected via a four-wire method; a starting voltage was set to -0.2 V, a cutoff voltage to 1.2 V, and a scanning speed to 200 mV/s. Reverse/forward (reverse/forward) scans were then performed, and short-circuit current density (Jsc), open-circuit voltage (Voc), and fill factor (FF) were recorded.

Then, the photoelectric conversion efficiency (PCE) of the perovskite solar cell was calculated using the formula: PCE = Jsc × Voc × FF / light power density × 100%.

### (2) Photoaging test

Specific test process: At 85°C, the perovskite solar cell was placed under sunlight at a light power density of 100 mW/cm² and encapsulated in a nitrogen box, the maximum power point voltage of the solar cell was dynamically monitored, and time, power, current, and voltage were recorded. The perovskite solar cell was aged in nitrogen for 1000 h.

After aging, the perovskite solar cell was taken out and subjected to the above photoelectric conversion efficiency test. Specifically, the test fixture and Keithley 2400 digital source meter were connected via a four-wire method; a starting voltage was set to -0.2 V, a cutoff voltage to 1.2 V, and a scanning speed to 200 mV/s. Reverse/forward scans were then performed, and short-circuit current density (Jsc), open-circuit voltage (Voc), and fill factor (FF) were recorded.

Then, the photoelectric conversion efficiency (PCE) of the photoaged perovskite solar cell was calculated and compared with the PCE of the unaged perovskite solar cell. The photoaging test results reflect the stability of the perovskite solar cell. Under the same aging time, the closer the aged efficiency was to the initial efficiency, the better the stability of the cell.

The parameters and performance data of the perovskite solar cells in the above examples and comparative examples are shown in Table 1 and Table 2.

**Table 1**

| Item | | Example 1 | Example 2 | Example 3 | Example 4 | Example 5 | Example 6 | Example 7 | Example 8 |
|---|---|---|---|---|---|---|---|---|---|
| | First additiv e | Polymethyl methacrylate | Methacrylic acid-methyl methacrylate copolymer | Poly(4-vinylpyridine) | 4-Vinylpyridine-styrene copolymer | Polymethyl methacrylate | Polymethyl methacrylate | Polymethyl methacrylate | Polymethyl methacrylate |
| Electr on transp ort layer | Conten t of first additiv e (wt%) | 5% | 5% | 5% | 5% | 5% | 5% | 5% | 5% |
| | Second additiv e | Tetrabutylammoniu m tetrafluoroborate | Tetrabutylammoniu m tetrafluoroborate | Tetrabutylammoniu m tetrafluoroborate | Tetrabutylammoniu m tetrafluoroborate | Tris(dimethylamino ethyl)amine | 1,7-Bis(dimethylamino )heptane | 9,9-Bis[3-(dimethylamino)pro pyl]fluorene | Hexamethylenedia mmonium iodide |
| | Conten t of second additiv e (wt%) | 1% | 1% | 1% | 1% | 1% | 1% | 1% | 1% |
| | Organi cmateri al | PCBM | PCBM | PCBM | PCBM | PCBM | PCBM | PCBM | PCBM |
| | Solven t and volum e ratio | 2-Methylanisole:chlo roform=1:1 | 2-Methylanisole:chlo roform=1:1 | 2-Methylanisole:chlo roform=1:1 | 2-Methylanisole:chlo roform=1:1 | 2-Methylanisole:chlor oform=1:1 | 2-Methylanisole:chlo reform=1:1 | 2-Methylanisole:chlor oform=1:1 | 2-Methylanisole:chlo roform=1:1 |
| Perov skite cell | Conver sion efficie ncy (%) | 22.2 | 21.8 | 22.1 | 22.5 | 21.5 | 21.7 | 21.5 | 21.2 |
| | Efficie ncy after 1000 hours at 85°C aging (%) | 21.5 | 21.0 | 21.3 | 21.4 | 20.9 | 20.8 | 20.5 | 20.5 |

**Table 2**

| Item | | Example 9 | Example 10 | Example 11 | Example 12 | Example 13 | Example 14 | Comparative Example 1 | Comparative Example 2 | Comparative Example 3 |
|---|---|---|---|---|---|---|---|---|---|---|
| Elect ron trans port layer | First additi ve | Polymethyl methacrylate | Polymethyl methacrylate | Polymethyl methacrylate | Polymethyl methacrylate | Polymethyl methacrylate | Polymethyl methacrylate | / | Polyethylene | Polymethyl methacrylate |
| | Conte nt of first additi ve (wt%) | 5% | 5% | 5% | 5% | 1% | 5% | / | 5% | 5% |
| | Secon d additi ve | Dodecyltrimethy lammonium bromide | Tris(dimethylami noethyl)amine, Tetrabutylammon ium tetrafluoroborate | Tetrabutylamino nium tetrafluoroborate | Tetrabutylammo nium tetrafluoroborate | Tetrabutylammo nium tetrafluoroborate | Tetrabutylammoniu m tetrafluoroborate | / | Tetrabutylammo nium tetrafluoroborate | Tris(3-aminopropyl)ami ne |
| | Conte nt of secon d additi ve (wt%) | 1% | 1%, 1% | 1% | 1% | 1% | 1% | / | 1% | 1% |
| | Organ ic materi al | PCBM | PCBM | Naphthalene diimide | Perylene diimide | PCBM | PCBM | PCBM | PCBM | PCBM |
| | Solve nt and volum e ratio | 2-Methylanisole:ch loroform=1:1 | 2-Methylanisole:chl oroform=1:1 | 2-Methylanisole:ch loroform=1:1 | 2-Methylanisole:ch loroform=1:1 | 2-Methylanisole:ch loroform=1:1 | Chlorobenzene:dichl oromethane=1:2 | 2-Methylanisole:ch loroform=1:1 | 2-Methylanisole:ch loroform=1:1 | 2-Methylanisole:ch loroform=1:1 |
| Perov skite cell | Conv ersion efficie ncy (%) | 21.5 | 22.6 | 21.0 | 20.8 | 21.7 | 22.1 | 19.5 | 20.4 | 20.7 |
| | Effici ency after 1000 hours at 85°C aging (%) | 20.3 | 21.7 | 20.1 | 19.8 | 20.5 | 21.0 | 16.8 | 18.5 | 18.7 |

From the above examples and comparative examples, it can be seen that in the electron transport layers containing the organic electron transport materials in the cells of the examples of this application, specific polymer macromolecules containing lone pair electrons such as O and N atoms are used as the first additive, and specific quaternary ammonium salts corresponding to the compound of general formula I and tertiary amine molecules corresponding to the compound of general formula II are used as the second additive, resulting in perovskite solar cells with the photoelectric conversion efficiency and stability superior to those of Comparative Examples 1 to 3.

The various technical features of the above-described embodiments may be arbitrarily combined. For the sake of brevity in description, not all possible combinations of the various technical features in the above embodiments are described. However, as long as there is no contradiction in the combinations of these technical features, all such combinations shall be deemed to fall within the scope recorded in this specification.

The above-described embodiments only express several implementation modes of this application, with relatively specific and detailed descriptions, but should not be construed as limiting the inventive scope of the in this application. It should be noted that for those of ordinary skill in the art, several variations and improvements can be made without departing from the concept of this application, which all fall within the protection scope of this application. Therefore, the protection scope of this application patent shall be subject to the appended claims, and the specification and drawings can be used to interpret the content of the claims.

## Claims

1. A perovskite solar cell, comprising a transparent electrode layer and, a perovskite layer, an electron transport layer, and a metal electrode sequentially disposed on the transparent electrode layer; wherein
the electron transport layer comprises an organic electron transport material, a first additive, and a second additive;
the first additive comprises one or more of polymethyl methacrylate, methacrylic acid-methyl methacrylate copolymer, 4-vinylpyridine-styrene copolymer, polyacrylonitrile, and poly(4-vinylpyridine); and
the second additive comprises one or more of the following compound of formula I and compound of formula II: 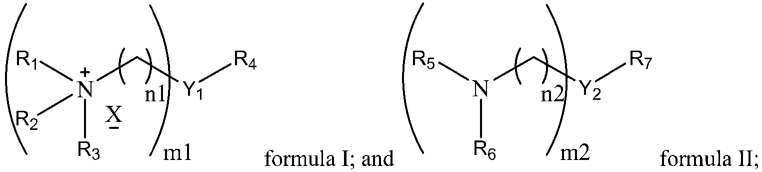
wherein R₁, R₂, R₃, R₅, and R₆ are each independently selected from C₁-C₄ alkyl; n1 and n2 are each independently an integer from 1 to 6; m1 and m2 are each independently an integer from 1 to 4; R₄ and R₇ are each independently selected from C₁-C₅ alkyl, C₁-C₅ alkoxy, C₁-C₅ alkylthio, aryl, halogen, carboxyl, cyano, or absent; X is one or more of Cl, Br, I, BF₄, PF₆, and TFSI; and Y₁ and Y₂ are each independently selected from any one of CH₂, NH, O, and S, or absent.

2. The perovskite solar cell according to claim 1, wherein, based on a total mass of the electron transport layer, a mass fraction of the first additive is 1% to 5%, a mass fraction of the second additive is 0.5% to 2%, and a mass fraction of the organic electron transport material is 93% to 98.5%.

3. The perovskite solar cell according to claim 1 or 2, wherein the second additive comprises the compound of formula I and the compound of formula II, and a mass ratio of the compound of formula I to the compound of formula II is (0.5 to 2):1.

4. The perovskite solar cell according to any one of claims 1 to 3, wherein the compound of formula I comprises one or more of tetrabutylammonium tetrafluoroborate, hexamethylenediammonium iodide, and dodecyltrimethylammonium bromide.

5. The perovskite solar cell according to any one of claims 1 to 4, wherein the compound of formula II comprises one or more of 1,7-bis(dimethylamino)heptane, tris(dimethylaminopropyl)amine, and 9,9-bis[3-(dimethylamino)propyl]fluorene.

6. The perovskite solar cell according to any one of claims 1 to 5, wherein a thickness of the electron transport layer is 25 nm to 45 nm.

7. The perovskite solar cell according to any one of claims 1 to 6, wherein the organic electron transport material comprises one or more of fullerene derivatives, naphthalene diimide and derivatives thereof, and perylene diimide and derivatives thereof.

8. A method for preparing the perovskite solar cell according to any one of claims 1 to 7, comprising the following steps:
providing the transparent electrode layer; and
sequentially forming the perovskite layer, the electron transport layer, and the metal electrode on the transparent electrode layer;
wherein a solution for forming the electron transport layer comprises a solvent and a solute dispersed in the solvent, and the solute comprises the organic electron transport material, the first additive, and the second additive.

9. The method for preparing the perovskite solar cell according to claim 8, wherein the solvent comprises a first organic solvent and a second organic solvent, a boiling point of the first organic solvent is 38°C to 70°C, and a boiling point of the second organic solvent is 110°C to 210°C.

10. The method for preparing the perovskite solar cell according to claim 9, wherein the first organic solvent comprises one or more of chloroform, dichloromethane, and tetrahydrofuran.

11. The method for preparing the perovskite solar cell according to claim 9 or 10, wherein the second organic solvent comprises one or more of chlorobenzene, o-dichlorobenzene, toluene, o-xylene, anisole, 2-methylanisole, 2-chlorophenol, and 1,2,3,4-tetrahydronaphthalene.

12. The method for preparing the perovskite solar cell according to any one of claims 9 to 11, wherein based on a total volume of the solvent, a volume fraction of the first organic solvent is 20% to 80%, and a volume fraction of the second organic solvent is 20% to 80%.

13. The method for preparing the perovskite solar cell according to any one of claims 8 to 12, wherein based on a total mass of the solution, the mass fraction of the first additive is 0.2‰ to 1‰, the mass fraction of the second additive is 0.1‰ to 0.4‰, and the mass fraction of the organic electron transport material is 1.86% to 1.97%.

14. The method for preparing the perovskite solar cell according to any one of claims 8 to 13, wherein based on a total mass of the solute, the mass fraction of the first additive is 1% to 5%, the mass fraction of the second additive is 0.5% to 2%, and the mass fraction of the organic electron transport material is 93% to 98.5%.

15. A photovoltaic module, comprising the perovskite solar cell according to any one of claims 1 to 7.

16. A photovoltaic system, comprising the photovoltaic module according to claim 15.

17. An electric device, comprising at least one of the perovskite solar cell according to any one of claims 1 to 7 and the photovoltaic module according to claim 15.
